# EUROPEAN PATENT APPLICATION

(11) **EP 4 597 765 A1**
(43) Date of publication of application: **06.08.2025**
(21) Application number: 23872466.0
(22) Date of filing: 27.09.2023
(51) Int. Cl.: H01S 5/042, H01L 33/00, H01S 5/022, H01S 5/02251, H01S 5/40

(54) **SEMICONDUCTOR MODULE**

(30) Priority: 29.09.2022 JP 2022156867
(71) Applicant: Kyocera Corporation, Kyoto-shi, Kyoto 612-8501 (JP)
(72) Inventor: AKAHOSHI, Tomoyuki, Kyoto-shi, Kyoto 612-8501 (JP)
(74) Representative: Viering, Jentschura & Partner mbB Patent- und Rechtsanwälte
(86) International application number: PCT/JP2023/035272
(87) International publication number: WO 2024/071244

(57) **Abstract**

The semiconductor module includes a substrate, a plurality of semiconductor elements located on the substrate, and a control IC located on the substrate and configured to control the plurality of semiconductor elements. Each of the plurality of semiconductor elements includes a light emitting element. An initial value of a drive current value that differs by the light emitting element is preset in the control IC.

## Description

### TECHNICAL FIELD

The embodiment of the present disclosure relates to a semiconductor module.

### BACKGROUND OF INVENTION

Known semiconductor modules include a semiconductor module in which a semiconductor element (hereinafter also referred to as an optical element) for converting an electrical signal into an optical signal is mounted on a substrate. An optical fiber cable for transmitting the converted optical signal from the optical element to the outside may be connected to the semiconductor module (see Patent Document 1).

### CITATION LIST

### PATENT LITERATURE

Patent Document 1: JP 2020-9824 A

### SUMMARY

In the present disclosure, a semiconductor module includes a substrate, a plurality of semiconductor elements, and a control IC. The plurality of semiconductor elements is located on the substrate. The control IC is located on the substrate and controls the plurality of semiconductor elements. Each of the plurality of semiconductor elements includes a light emitting element. An initial value of a drive current value that differs by the light emitting element is preset in the control IC.

### BRIEF DESCRIPTION OF THE DRAWINGS

FIG. 1 is a perspective view of a semiconductor module according to an embodiment, as viewed from diagonally above.
FIG. 2 is a perspective view of the semiconductor module according to the embodiment, as viewed from diagonally below.
FIG. 3 is a plan view of the semiconductor module according to the embodiment.
FIG. 4 is a functional block diagram of the semiconductor module according to the embodiment.
FIG. 5 is a diagram illustrating a light emitting operation of the semiconductor module in a reference example.
FIG. 6 is a graph showing an example of a light emission amount of each of optical elements in the reference example.
FIG. 7 is a diagram illustrating the light emitting operation of the semiconductor module according to the embodiment.
FIG. 8 is a graph showing an example of a light emission amount of each of the optical elements according to the embodiment.
FIG. 9 is a plan view of the semiconductor module according to the embodiment.
FIG. 10 is a plan view of the semiconductor module according to the embodiment.

### DESCRIPTION OF EMBODIMENTS

Hereinafter, an embodiment of a semiconductor module disclosed in the present application will be described with reference to the accompanying drawings. The present disclosure is not limited by the following embodiments. Embodiments can be appropriately combined within a range so as not to contradict each other in terms of processing content. In the following embodiments, the same portions are denoted by the same reference signs, and redundant descriptions are omitted.

In the following embodiments, expressions such as "constant", "orthogonal", "perpendicular", and "parallel" may be used, but these expressions need not mean exactly "constant", "orthogonal", "perpendicular", and "parallel". That is, each of the expressions described above allows for deviations in, for example, manufacturing accuracy or installation accuracy.

In each of the drawings, which will be referred to below, for ease of explanation, an X axis direction, a Y axis direction, and a Z axis direction that are orthogonal to each other may be defined to illustrate a rectangular coordinate system in which a Z axis positive direction is a vertically upward direction.

Known semiconductor modules include a semiconductor module in which a semiconductor element (hereinafter also referred to as an optical element) for converting an electrical signal into an optical signal is mounted on a substrate. An optical fiber cable for transmitting the converted optical signal from the optical element to the outside may be connected to the semiconductor module.

However, in the above-described known technology, when a plurality of the optical elements is mounted on the semiconductor module, light emission amounts of the respective optical elements may vary. As a result, amplitudes and/or median values of the optical signal output from the semiconductor module vary. Thus, a signal quality of the optical signal may be degraded.

Technology is awaited that can overcome the above-described problems and improve signal quality of an optical signal output from a semiconductor module.

### Configuration of Semiconductor Module

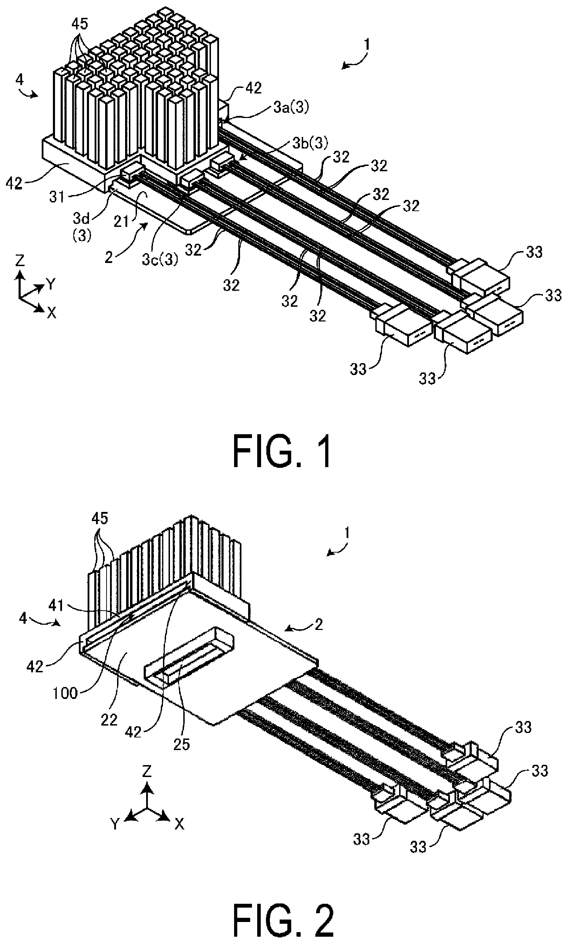

First, a configuration of a semiconductor module 1 according to an embodiment will be described with reference to FIGs. 1 to 3. FIG. 1 is a perspective view of the semiconductor module 1 according to the embodiment, as viewed from diagonally above. FIG. 2 is a perspective view of the semiconductor module 1 according to the embodiment, as viewed from diagonally below.

Note that each of the following embodiments describes an example in which the semiconductor module 1 is an optical module in which optical elements 3 are mounted on a substrate. However, a semiconductor module according to the present disclosure is not necessarily an optical module.

As illustrated in FIGs. 1 and 2, the semiconductor module 1 according to the embodiment includes a substrate 2, the plurality of optical elements 3 (optical elements 3a to 3d), and a heat dissipation member 4. The optical elements 3 are an example of semiconductor elements.

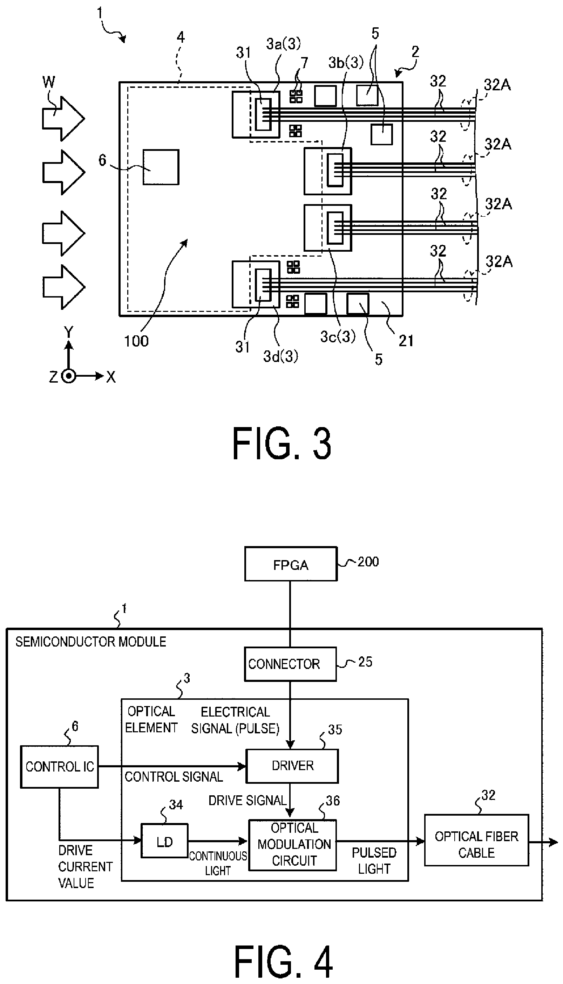

The substrate 2 has a quadrilateral plate shape in a plan view, for example. In addition to the plurality of optical elements 3a to 3d and the heat dissipation member 4, a power supply IC 5, a control IC 6, a plurality of passive components 7, and the like (refer to FIG. 3 for all) are located on a first surface 21 (here, the upper surface) of the substrate 2. Examples of the passive components 7 include a resistor, a capacitor, and a coil.

A connector 25 is located on a second surface 22 (here, the lower surface) of the substrate 2. The substrate 2 is electrically connected to a motherboard via the connector 25.

The optical elements 3 are semiconductor elements that convert electrical signals into optical signals. Alternatively, the optical elements 3 may convert optical signals into electrical signals. An interface portion 31 is located on the upper surface of each of the optical elements 3. The interface portion 31 is connected to an optical connector 33 via a cable group 32A (refer to FIG. 3). The cable group 32A is made up of a plurality of optical fiber cables 32.

The heat dissipation member 4 is a so-called heat sink, and is located above the plurality of optical elements 3. Note that the heat dissipation member 4 does not necessarily cover the entirety of the plurality of optical elements 3 from above. That is, as illustrated in FIG. 1, the upper surfaces of the plurality of optical elements 3 may be partially exposed from the heat dissipation member 4.

The heat dissipation member 4 is close to the plurality of optical elements 3, and dissipates heat generated from the optical elements 3 to the outside of the semiconductor module 1. Note that the heat dissipation member 4 may be in direct contact with the optical elements 3. Alternatively, the heat dissipation member 4 may be in contact with the optical elements 3 via a thermal interface material (TIM). That is, the heat dissipation member 4 may be thermally connected to the plurality of optical elements 3.

The heat dissipation member 4 may be made from a metal having relatively high thermal conductivity, such as aluminum, copper, or iron. TIM is a composite material containing a filler in a resin. The filler has thermal conductivity.

The heat dissipation member 4 includes a plate-shaped portion 41, a plurality of leg portions 42, and a plurality of heat dissipation bodies 45. The plate-shaped portion 41 is a plate-shaped portion disposed facing the first surface 21 of the substrate 2, with a gap therebetween. The plurality of leg portions 42 are provided on the plate-shaped portion 41. Specifically, the plurality of leg portions 42 extend from the plate-shaped portion 41 toward the substrate 2 and come into contact with the substrate 2 (are installed on the substrate 2).

Each of the leg portions 42 has a shape in which the thickness thereof partially increases from the plate-shaped portion 41. The leg portions 42 may be integrated with the plate-shaped portion 41. The plurality of leg portions 42 may be connected to the plate-shaped portion 41 and the substrate 2. The plurality of leg portions 42 extend in a given direction (here, in the X axis direction).

The plurality of heat dissipation bodies 45 are located on a surface of the plate-shaped portion 41, on an opposite side to a surface of the plate-shaped portion 41, facing the substrate 2. FIGs. 1 and 2 illustrate an example in which each of the heat dissipation bodies 45 is pin-shaped (that is, a heat dissipation pin). However, each of the heat dissipation bodies 45 may be plate-shaped (that is, a heat dissipation fin).

FIG. 3 is a plan view of the semiconductor module 1 according to the embodiment. Note that, in FIG. 3, the heat dissipation member 4 is illustrated with a dashed line in order to facilitate understanding.

As illustrated in FIG. 3, when viewed along the extending direction (X axis direction) of the optical fiber cables 32, the plurality of optical elements 3a to 3d are arranged along a direction (Y axis direction) orthogonal to the extending direction. Specifically, the plurality of optical elements 3a to 3d are arranged in the order of the optical element 3d, the optical element 3c, the optical element 3b, and the optical element 3a in the Y axis positive direction.

The plurality of optical elements 3a to 3d are spaced apart from each other. This configuration can reduce thermal interference between the plurality of optical elements 3a to 3d when the optical elements 3a to 3d are located on the substrate 2.

Specifically, as illustrated in FIG. 3, among the plurality of optical elements 3a to 3d, the optical element 3a and the optical element 3b located closest to the optical element 3a are displaced from each other in the extending direction of the optical fiber cables 32 (the X axis direction) and in the direction orthogonal to the extending direction (the Y axis direction). Similarly, among the plurality of optical elements 3a to 3d, the optical element 3d and the optical element 3c located closest to the optical element 3d are displaced from each other in the X axis direction and the Y axis direction.

As described above, the plurality of optical elements 3 are displaced from each other. Thus, in the embodiment, the size of the substrate 2 can be reduced, while securing a distance between the optical elements 3 that are adjacent to each other, in other words, while reducing the thermal interference between the adjacent optical elements 3.

Here, an example has been described in which the two adjacent optical elements (the optical elements 3a and 3b, for example) of the plurality of optical elements 3a to 3d are spaced apart from each other in the X axis direction and the Y axis direction. However, the present disclosure is not limited to this example. Of all the plurality of optical elements 3a to 3d, any two of the semiconductor elements adjacent to each other may be displaced from each other in the extending direction of the optical fiber cables 32 (the X axis direction) and in the direction orthogonal to the extending direction (the Y axis direction).

For example, the plurality of optical elements 3a to 3d may be disposed in a zig-zag manner. This can also reduce the size of the substrate 2, while reducing the thermal interference between the optical elements 3.

A blower (not illustrated), such as a cooling fan, for sending air to the semiconductor module 1 may be located on the negative side in the X axis direction relative to the semiconductor module 1. The blower generates an air flow W flowing toward the X axis positive direction.

The air flow W sent from the blower hits the plurality of heat dissipation bodies 45 (see FIG. 1) and flows along the first surface 21 of the substrate 2. The air flow W thus passes through a ventilation path 100 formed between the substrate 2 and the plate-like portion 41 of the heat dissipation member 4.

In the embodiment, since the air flow W hits the plurality of optical elements 3 located on an outlet side of the ventilation path 100, the plurality of optical elements 3 can have an improved heat dissipation efficiency.

In the embodiment, since the plurality of optical elements 3 are arranged along the direction (here, the Y axis direction) intersecting the direction of the air flow W, the air flow W hits all the optical elements 3 in a substantially uniform manner. Thus, according to the embodiment, the optical elements 3 can have an improved heat dissipation efficiency.

As illustrated in FIG. 3, the control IC 6 may be located below the heat dissipation member 4. The control IC 6 may be thermally connected to the heat dissipation member 4. Thus, heat generated from the control IC 6 can be efficiently dissipated by the heat dissipation member 4.

For example, a plurality of the power supply ICs 5 may be located on the substrate 2. Thus, power can be supplied to the optical elements 3 with a plurality of types of reference voltage.

The power supply ICs 5 may be located on the opposite side to the control IC 6 with respect to the optical elements 3, when the first surface 21 is viewed in a plan view. For example, the control IC 6 may be located on the negative side in the X axis direction relative to the optical elements 3, and the power supply ICs 5 may be located on the positive side in the X axis direction relative to the optical elements 3.

Accordingly, mutual interference can be reduced between the power supply ICs 5 and various wiring (not illustrated) located between the control IC 6 and the optical elements 3 on the first surface 21 of the substrate 2. Thus, according to the embodiment, a degree of freedom in the wiring design can be secured.

### Embodiments

Details of operations of the semiconductor module 1 according to the embodiment will be described with reference to FIGs. 4 to 10. FIG. 4 is a functional block diagram of the semiconductor module 1 according to the embodiment.

As illustrated in FIG. 4, the semiconductor module 1 according to the embodiment includes the optical elements 3, the control IC 6, the connector 25, and the optical fiber cables 32. Each of the optical elements 3 includes a laser diode (LD) 34, a driver 35, and an optical modulation circuit 36. The LD 34 is an example of a light emitting element.

The control IC 6 sets a drive current value of the LD 34 of the optical element 3 based on a preset initial value of the drive current value. The LD 34 emits light using the drive current of the set drive current value. Continuous light generated by the LD 34 is transmitted to the optical modulation circuit 36.

A pulsed electrical signal is input from an external field-programmable gate array (FPGA) 200 to the driver 35 of the optical element 3 via the connector 25. The pulsed electrical signal has a characteristic serving as a reference for the optical signal output from the optical element 3.

The driver 35 generates a drive signal for driving the optical modulation circuit 36 based on the electrical signal supplied from the FPGA 200. The driver 35 supplies the drive signal to the optical modulation circuit 36. A control signal supplied from the control IC 6 controls the ON/OFF of the operation of the driver 35, a degree of modulation of the pulse, and the like.

Based on the drive signal supplied from the driver 35, the optical modulation circuit 36 modulates the continuous light supplied from the LD 34 and generates pulsed light. The pulsed light generated by the optical modulation circuit 36 is transmitted to the outside via the optical fiber cables 32.

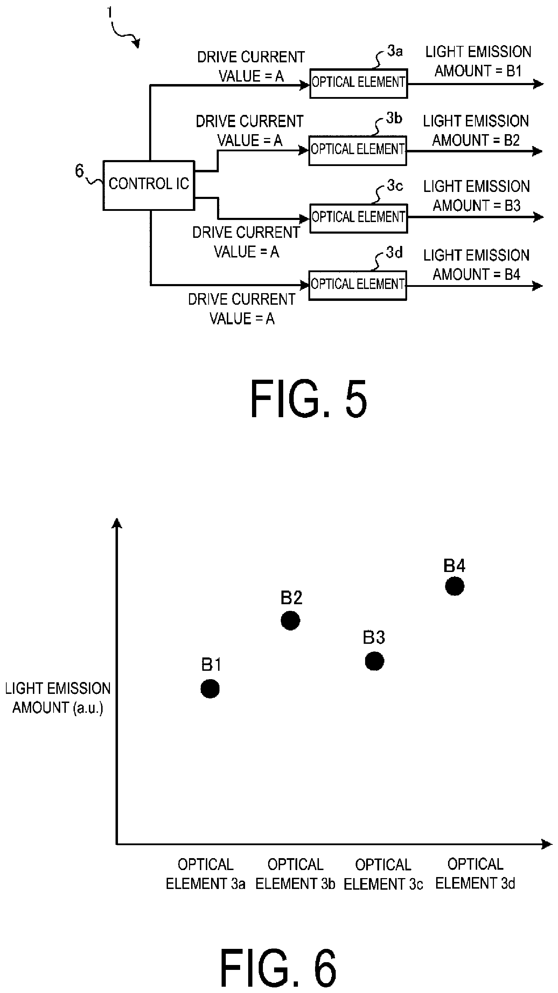

FIG. 5 is a diagram illustrating a light emitting operation of the semiconductor module 1 according to a reference example. As illustrated in FIG. 5, in the semiconductor module 1, a single control IC 6 controls all of the plurality of optical elements 3a to 3d.

In the reference example, all the initial values of the drive current values in the LDs 34 (see FIG. 4) individually located at the plurality of optical elements 3a to 3d are equal (drive current value = A). That is, in the reference example, the initial values of the drive current values in a plurality of LDs 34 are all equal. The initial values are preset in the control IC 6.

On the other hand, even when the initial values of the drive current values are all equal to each other, the light emission amounts of the optical elements 3a to 3d are not always the same as each other. This is because, even when the drive current values of the LDs 34 are uniform, other factors in each of the optical elements 3a to 3d are not completely uniform. Thus, the light emission amounts are not always the same.

That is, as shown in FIG. 6, a light emission amount B1 of the optical element 3a, a light emission amount B2 of the optical element 3b, a light emission amount B3 of the optical element 3c, and a light emission amount B4 of the optical element 3d may vary. FIG. 6 is a graph showing an example of the light emission amounts of each of the optical elements 3a to 3d in the reference example.

In this way, in the reference example, since the amplitudes and/or the median values of the optical signals output from the plurality of optical connectors 33 (see FIG. 1) vary, the signal quality of the optical signal output from the semiconductor module 1 may deteriorate.

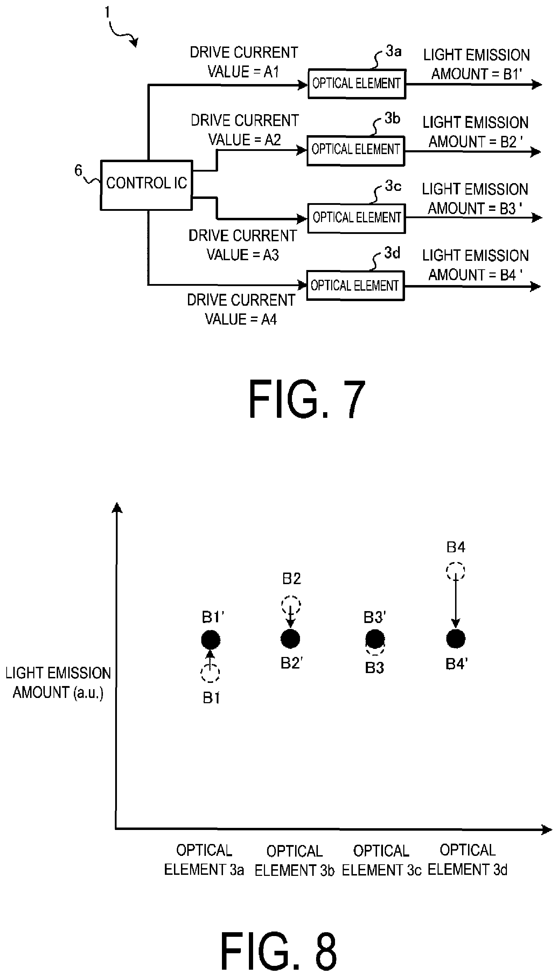

In the embodiment, as illustrated in FIG. 7, the control IC 6 may set different initial values (drive current values = A1 to A4) of the drive current values for the LDs 34 (see FIG. 4). That is, in the embodiment, the initial values of the drive current values that differ between the LDs 34 may be set in the control IC 6 in advance.

For example, the drive current value A1, which is larger than a drive current value A (see FIG. 5) illustrated in the reference example, is preset in the control IC 6 as the initial value for the LD 34 of the optical element 3a. In this way, as shown in FIG. 8, the optical element 3a emits a light emission amount B1' of light that is larger than the light emission amount B1 from the optical element 3a in the reference example.

As illustrated in FIG. 7, the drive current value A2, which is smaller than the drive current value A illustrated in the reference example, is preset in the control IC 6 as the initial value for the LD 34 of the optical element 3b. In this way, as shown in FIG. 8, the optical element 3b emits a light emission amount B2' of light that is smaller than the light emission amount B2 from the optical element 3b in the reference example.

As illustrated in FIG. 7, the drive current value A3, which is larger than the drive current value A illustrated in the reference example, is preset in the control IC 6 as the initial value for the LD 34 of the optical element 3c. In this way, as shown in FIG. 8, the optical element 3c emits a light emission amount B3' of light that is larger than the light emission amount B3 from the optical element 3c in the reference example.

As illustrated in FIG. 7, the drive current value A4, which is smaller than the drive current value A illustrated in the reference example, is preset in the control IC 6 as the initial value for the LD 34 of the optical element 3d. In this way, as shown in FIG. 8, the optical element 3d emits a light emission amount B4' of light that is smaller than the light emission amount B4 from the optical element 3d in the reference example.

As a result, as shown in FIG. 8, the light emission amounts B1' to B4' of all the optical elements 3a to 3d mounted on the semiconductor module 1 can become uniform. Thus, according to the embodiment, the signal quality of the optical signal output from the semiconductor module 1 can be improved.

In the embodiment, the initial values of the drive current values in the plurality of LDs 34 may be set in accordance with the respective light emission amounts of the optical elements 3a to 3d. For example, in the embodiment, the initial values of the drive current values in the plurality of LDs 34 may be set such that the respective light emission amounts of the plurality of optical elements 3a to 3d become equal to each other.

In this way, the optical signal output from the semiconductor module 1 can have improved signal quality.

In the embodiment, for example, after the semiconductor module 1 is assembled, the light emission amount of each of the optical elements 3 is measured when each of the optical elements 3 emits light using the same drive current value. Then, in accordance with the measured light emission amount of each of the optical elements 3, the initial values of the drive current values in the plurality of LDs 34 may be set so that the light emission amounts of all the optical elements 3 become equal to each other. In this way, the initial values of the drive current values in the plurality of LDs 34 can be set such that the light emission amounts of the plurality of optical elements 3a to 3d become equal to each other.

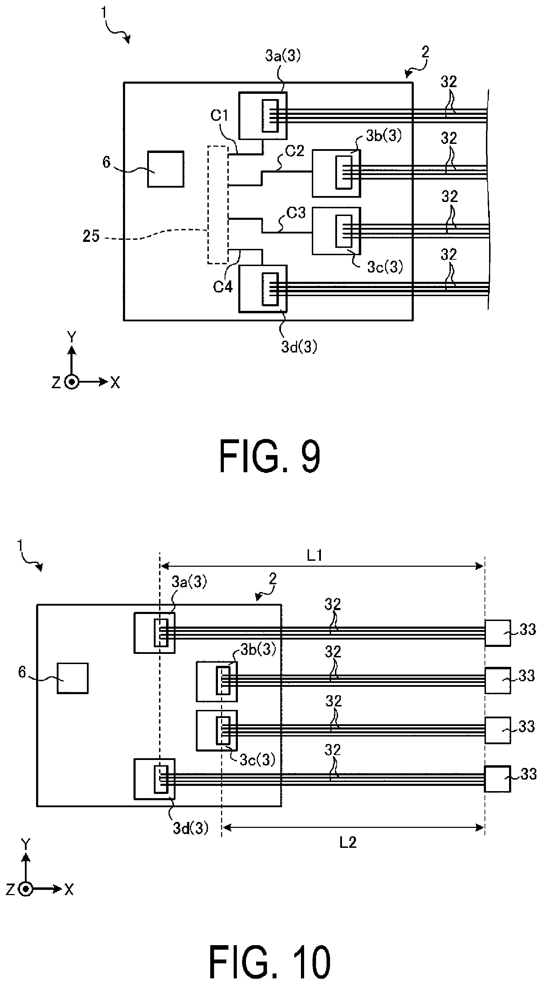

In the embodiment, the initial values of the drive current values in the plurality of LDs 34 may be set by means other than the above-described means. FIGs. 9 and 10 are plan views of the semiconductor module 1 according to the embodiment.

As illustrated in FIG. 9, in the embodiment, wires C1 to C4 are located on the substrate 2, and connect the connector 25 to the optical elements 3a to 3d, respectively. The wires C1 to C4 may have different wiring lengths. For example, in the example in FIG. 9, the wires C2 and C3 connecting the connector 25 to the optical elements 3b and 3c, respectively, are longer than the wires C1 and C4 connecting the connector 25 to the optical elements 3a and 3d, respectively.

In this way, the electrical signal input from FPGA 200 (see FIG. 4) via the connector 25 may be more significantly attenuated before reaching the optical elements 3b and 3c than before reaching the optical elements 3a and 3d. In this case, the light emission amounts from the optical elements 3b and 3c may be smaller than the light emission amounts from the optical elements 3a and 3d.

Thus, in the embodiment, the initial value of the drive current value in the LD 34 of each of the optical elements 3a to 3d may be set in accordance with the wiring length between the connector 25 and a respective one of the optical elements 3a to 3d. For example, in the embodiment, the initial value of the drive current value in the LD 34 of each of the optical elements 3a to 3d may be set to increase as the wiring length between the connector 25 and a respective one of the optical elements 3a to 3d increases.

In the example in FIG. 9, the initial values of the drive current values in the LDs 34 of the optical elements 3b and 3c may be set to be larger than the initial values of the drive current values in the LDs 34 of the optical elements 3a and 3d.

In this way, the light emission amounts of the plurality of optical elements 3a to 3d become equal to each other. Thus, the optical signal output from the semiconductor module 1 can have improved signal quality. According to the embodiment, even when the lengths of the wires C1 to C4 are not set to the same length, the light emission amounts of the plurality of optical elements 3a to 3d still become equal to each other. Thus, the degree of freedom in the wiring design can be secured.

As illustrated in FIG. 10, in the embodiment, the lengths of the optical fiber cables 32 respectively connected to the optical elements 3a to 3d may differ from each other. For example, in the example in FIG. 10, a length L1 of the optical fiber cables 32 connected to the optical elements 3a and 3d is greater than a length L2 of the optical fiber cables 32 connected to the optical elements 3b and 3c.

As a result, the optical signals transmitted from the optical elements 3a and 3d to the optical connectors 33 via the optical fiber cables 32 may be more significantly attenuated than the optical signals transmitted from the optical elements 3b and 3c to the optical connectors 33 via the optical fiber cables 32.

In this case, the amplitudes and/or the median values of the optical signals transmitted from the optical elements 3a and 3d to the optical connectors 33 may be smaller than the amplitudes and/or the median values of the optical signals transmitted from the optical elements 3b and 3c to the optical connectors 33.

Thus, in the embodiment, the initial value of the drive current value in the LD 34 of each of the optical elements 3a to 3d may be set in accordance with the length of the optical fiber cable 32 connected to a respective one of the optical elements 3a to 3d. For example, in the embodiment, the initial values of the drive current values in the LDs 34 may be set to increase as the length of the optical fiber cables 32 connected to the optical elements 3a to 3d increases.

In the example in FIG. 10, the initial values of the drive current values in the LDs 34 of the optical elements 3a and 3d may be set to be larger than the initial values of the drive current values in the LDs 34 of the optical elements 3b and 3c.

In this way, the amplitudes and/or the median values of the optical signals transmitted to all the optical connectors 33 become equal. Thus, the optical signal output from the semiconductor module 1 can have improved signal quality.

In the embodiment, the control IC 6 may have a correction function of correcting the drive current value of the LD 34 in each of the optical elements 3a to 3d based on the light emission amount of each of the optical elements 3a to 3d. The control IC 6 may use a preset initial value of the drive current value (for example, the drive current values A1 to A4 (see FIG. 7)) as an initial value for the correction function.

Accordingly, the correction amount for the drive current value by the correction function can be reduced, compared to using the drive current value A (refer to FIG. 5), which is uniform in all the optical elements 3a to 3d, as the initial value for the correction function.

Therefore, according to the embodiment, a configuration of a correction circuit for realizing the function function can be simplified. Thus, manufacturing costs of the semiconductor module 1 can be reduced.

According to the embodiment, the configuration of the correction circuit for realizing the function function can be simplified. Additionally, the correction function can be implemented without excessively illuminating the LD 34. Thus, power consumption of the semiconductor module 1 can be reduced.

Although the embodiment of the present disclosure has been described above, the present disclosure is not limited to the embodiment described above, and various changes can be made without departing from the spirit of the present disclosure. For example, in the above-described embodiment, the example is described in which the laser diode is used as the light emitting element mounted on the optical element 3. However, the present disclosure is not limited to this example, and a light emitting diode (LED) or the like may be mounted as the light emitting element.

Additional effects and other aspects can be easily derived by a person skilled in the art. Thus, a wide variety of aspects of the present disclosure are not limited to the specific details and representative embodiments represented and described above. Accordingly, various changes are possible without departing from the spirit or scope of the general inventive concepts defined by the appended claims and their equivalents.

Note that the present technique can also have the following configurations.
(1) A semiconductor module includes a substrate, a plurality of semiconductor elements located on the substrate, and a control IC located on the substrate and configured to control the plurality of semiconductor elements, in which each of the plurality of semiconductor elements includes a light emitting element, and an initial value of a drive current value that differs by the light emitting element is preset in the control IC.
(2) In the semiconductor module according to (1) above, the initial value of the drive current value of the light emitting element is set in accordance with a light emission amount of a semiconductor element of the plurality of semiconductor elements.
(3) In the semiconductor module according to (2) above, the initial value of the drive current value of the light emitting element is set such that light emission amounts of the plurality of semiconductor elements become equal to each other.
(4) The semiconductor module according to any one of (1) to (3) above further includes a connector configured to receive an electrical signal from outside, the electrical signal serving as a reference for an optical signal to be output from the light emitting element, in which the initial value of the drive current value of the light emitting element is set in accordance with a wiring length between the connector and the semiconductor element.
(5) In the semiconductor module according to (4) above, the initial value of the drive current value of the light emitting element is set to increase as the wiring length increases.
(6) The semiconductor module according to any one of (1) to (5) above further includes a plurality of optical fiber cables respectively connected to the plurality of semiconductor elements, in which the initial value of the drive current value of the light emitting element is set in accordance with a length of an optical fiber cable of the plurality of optical fiber cables.
(7) In the semiconductor module according to (6) above, the initial value of the drive current value of the light emitting element is set to increase as the length of the optical fiber cable increases.
(8) In the semiconductor module according to any one of (1) to (7) above, the control IC has a correction function configured to correct the drive current value of the light emitting element based on the light emission amount of the semiconductor element, and the control IC uses the initial value of the drive current value having been preset, as an initial value for the correction function.

### REFERENCE SIGNS

1 Semiconductor module
2 Substrate
25 Connector
3, 3a to 3d Optical element (example of semiconductor element)
32 Optical fiber cable
33 Optical connector
34 LD (example of light emitting element)
35 Driver
36 Optical modulation circuit
6 Control IC

## Claims

1. A semiconductor module comprising:
a substrate;
a plurality of semiconductor elements located on the substrate; and
a control IC located on the substrate and configured to control the plurality of semiconductor elements, wherein
each of the plurality of semiconductor elements comprises a light emitting element, and
an initial value of a drive current value that differs by the light emitting element is preset in the control IC.

2. The semiconductor module according to claim 1, wherein
the initial value of the drive current value of the light emitting element is set in accordance with a light emission amount of a semiconductor element of the plurality of semiconductor elements.

3. The semiconductor module according to claim 2, wherein
the initial value of the drive current value of the light emitting element is set such that light emission amounts of the plurality of semiconductor elements become equal to each other.

4. The semiconductor module according to any one of claims 1 to 3, further comprising a connector configured to receive an electrical signal from outside, the electrical signal serving as a reference for an optical signal to be output from the light emitting element, wherein
the initial value of the drive current value of the light emitting element is set in accordance with a wiring length between the connector and the semiconductor element.

5. The semiconductor module according to claim 4, wherein
the initial value of the drive current value of the light emitting element is set to increase as the wiring length increases.

6. The semiconductor module according to any one of claims 1 to 5, further comprising a plurality of optical fiber cables respectively connected to the plurality of semiconductor elements, wherein
the initial value of the drive current value of the light emitting element is set in accordance with a length of an optical fiber cable of the plurality of optical fiber cables.

7. The semiconductor module according to claim 6, wherein
the initial value of the drive current value of the light emitting element is set to increase as the length of the optical fiber cable increases.

8. The semiconductor module according to any one of claims 1 to 7, wherein
the control IC comprises a correction function configured to correct the drive current value of the light emitting element based on the light emission amount of the semiconductor element, and
the control IC uses the initial value of the drive current value having been preset, as an initial value for the correction function.
